# EUROPEAN PATENT APPLICATION

(11) **EP 4 663 820 A1**
(43) Date of publication of application: **17.12.2025**
(21) Application number: 24203577.2
(22) Date of filing: 30.09.2024
(51) Int. Cl.: C30B 23/00, C30B 29/36, C30B 35/00

(54) **MANAGING THE GROWTH OF SILICON CARBIDE CRYSTALS**

(30) Priority: 10.06.2024 US 202418738193
(71) Applicant: Semiconductor Components Industries, LLC, Scottsdale, AZ 85250 (US)
(72) Inventor: PARTHASARATHY, Santhanaraghavan, Nashua, NH, 03063 (US); V. DRACHEV, Roman, Bedford, NH, 03110 (US)
(74) Representative: Manitz Finsterwald Patent- und Rechtsanwaltspartnerschaft mbB

(57) **Abstract**

SiC substrates are in demand for high power applications such as electric vehicles, solar panels, and industrial electronics. A physical vapor transport (PVT) apparatus for growth of silicon carbide (SiC) ingots can be improved by incorporating a moveable source. During growth of the ingot, the shape of the growth interface can be maintained as a convex shape by keeping a substantially constant distance between the growth interface and the source material. It is shown that temperature gradients during the growth phase are also influenced by the shape of the growth interface. By moving the source during crystal growth, the resulting SiC ingot can be taller with fewer defects, and can be less likely to crack during subsequent grinding or polishing operations.

## Description

### CROSS-REFERENCE TO RELATED APPLICATION

This patent application claims the benefit of U.S. Patent Application No. 18/738,193, filed on June 10, 2024, and titled "Managing the Growth of Silicon Carbide Crystals," which is incorporated by reference herein in its entirety.

### TECHNICAL FIELD

This description relates to a method and apparatus for growing silicon carbide (SiC) crystals for use in the electronics industry. More specifically, this description relates to controlling SiC crystal growth in a physical vapor transport (PVT) furnace.

### BACKGROUND

Silicon carbide can be used as an alternative substrate material to silicon in the fabrication of integrated circuits. Some useful properties of SiC-based microchips, e.g., metal-oxide-semiconductor field effect transistors (SiC MOSFETs) include reduced weight, low power consumption, and the ability to sustain high temperature operation. Whereas silicon devices operate at temperatures up to about 120 degrees C, SiC devices can operate at temperatures as high as 500 degrees C to 800 degrees C, due to the high thermal conductivity of SiC, which is about 3.5 times greater than that of silicon. SiC devices are therefore particularly suited for power applications such as electric vehicles (EVs), hybrid electric vehicles (HEVs), solar panels, and industrial applications. SiC devices have been inserted into EV production in vehicle components such as DC-DC converters and on-board fast battery chargers.

### SUMMARY

In some aspects, the techniques described herein relate to an apparatus, including: a crucible having an upper region and a lower region; a silicon carbide (SiC) precursor disposed in a moveable source capsule in the lower region; a SiC seed disposed in the upper region; and an inductive heater coil surrounding at least a portion of a sidewall of the crucible.

In some aspects, the techniques described herein relate to a system, including: a process chamber for growing a SiC crystal; a moveable SiC source capsule disposed inside the process chamber; a heater disposed around sides of the process chamber; and a controller configured to control a position of the moveable SiC source capsule.

In some aspects, the techniques described herein relate to a method of forming silicon carbide, including: disposing a SiC precursor in a moveable source capsule in a lower region of a crucible; disposing a SiC seed in a fixed seed module in an upper region of the crucible; heating the source capsule; forming a SiC crystal by condensing SiC on surfaces of the SiC seed; and moving the source capsule relative to the fixed seed module while forming the SiC crystal.

### BRIEF DESCRIPTION OF THE DRAWINGS

FIG. 1 is a high level cross-sectional view of a physical vapor transport (PVT) apparatus, according to implementations of the present disclosure.
FIG. 2 is a detailed cross-sectional view of a physical vapor transport (PVT) apparatus, according to implementations of the present disclosure.
FIG. 3 is a detailed cross-sectional view of a physical vapor transport (PVT) apparatus, according to implementations of the present disclosure.
FIG. 4A is a side elevation view of a crystalline boule, according to implementations of the present disclosure.
FIGs. 4B and 4C are examples of convex growth interfaces, according to implementations of the present disclosure.
FIG. 5A is a simulated temperature profile of a SiC boule that has a convex growth interface.
FIG. 5B is a simulated temperature profile of a SiC boule that has a substantially flat growth interface.
FIG. 5C is a simulated temperature profile of a SiC boule having a concave growth interface.
FIG. 6 is a cross-sectional view of a PVT apparatus showing the effect of source motion on temperature gradients during a simulated crystal growth process, according to implementations of the present disclosure.
FIG. 7 is a cross-sectional view of a PVT apparatus showing the effect of source motion on growth interface shape during a simulated crystal growth process, according to implementations of the present disclosure.
FIG. 8 is a flow diagram illustrating a method of forming a SiC boule, according to implementations of the present disclosure.
FIG. 9 is a system block diagram of a computer system that can provide feedback control for the process shown in FIG. 7, according to a possible implementation of the present disclosure.

Aspects of the present disclosure are best understood from the following detailed description when read with the accompanying figures. It is noted that, in accordance with common practice in the industry, various features are not necessarily drawn to scale. Dimensions of the various features may be arbitrarily increased or reduced for clarity of discussion. In the drawings, like reference symbols may indicate like and/or similar components (elements, structures, etc.) in different views. The drawings illustrate generally, by way of example, but not by way of limitation, various implementations discussed in the present disclosure. Reference symbols shown in one drawing may not be repeated for the same, and/or similar elements in related views. Reference symbols that are repeated in multiple drawings may not be specifically discussed with respect to each of those drawings but are provided for context between related views. Also, not all like elements in the drawings are specifically referenced with a reference symbol when multiple instances of an element are illustrated.

### DETAILED DESCRIPTION

Silicon carbide ingots for use in the fabrication of integrated circuits can be grown in a physical vapor transport (PVT) furnace. A PVT furnace can have the form of a vertical cylindrical chamber, or crucible, that has a seed crystal at one end. The crucible can receive source materials of silicon and carbon, which are heated until they vaporize. The resulting silicon and carbon gases rise within the chamber, and when the gas encounters the seed crystal, the gas crystalizes around the seed crystal, causing crystal growth radially outward as well as axially outward in a downward direction. Such crystal growth forms a cylindrical boule that can later be sliced into SiC wafers for use as substrates in a semiconductor fabrication process.

Process control during SiC crystal growth is challenging. At least one problem that occurs during the process of crystal growth is that, as the boule extends downward from the seed crystal, the distance between the crystallization surface of the growing crystal and the source zone is continuously changing. As the growth proceeds, the grown crystal comes closer to the source zone due to the advancement of the solid-gas interface. Consequently, the length of the boule is limited because the distance available for expansion is constantly shrinking. Meanwhile, the crystal growth interface changes shape from convex to flat, and then to concave, as the growth interface moves downward. Such changes in the interface shape and associated temperature profile can cause variation in the growth rate and the quality of the crystal, e.g., dislocation defects can form in the crystal structure. To minimize the dislocation density within the boule, it can be desirable to control the crystal-gas interface so as to maintain a convex shape throughout the growth process. In addition, maintaining an isothermal temperature profile at the growth interface can help produce a boule with a uniform, defect-free crystalline structure.

At least one way to control the interface shape and the temperature isotherms at the crystal growth interface is to move the source or the seed to compensate for the moving crystallization interface and thus maintain a constant distance therebetween. In addition, if coil heaters, e.g., RF coil heaters, are disposed at one or both ends of the crucible, it may be possible to maintain desired temperature isotherms by moving the coil(s) relative to the hot zone, instead of moving the source or the seed. (This approach is the subject of a separate patent application from the same inventors as the present patent application.) However, moving heaters does not change the distance between the source and the seed and therefore may not address the interface shape. Moving the seed would appear to be a simpler, more straightforward option. However, if a device that monitors the seed temperature is fixed in a location adjacent to the seed, the temperature measurement will not be accurate once the seed position changes. Unfortunately, it may not be practical to place a temperature detector on the growing crystal itself.. With these considerations, an approach to controlling crystal growth by moving the source is described below.

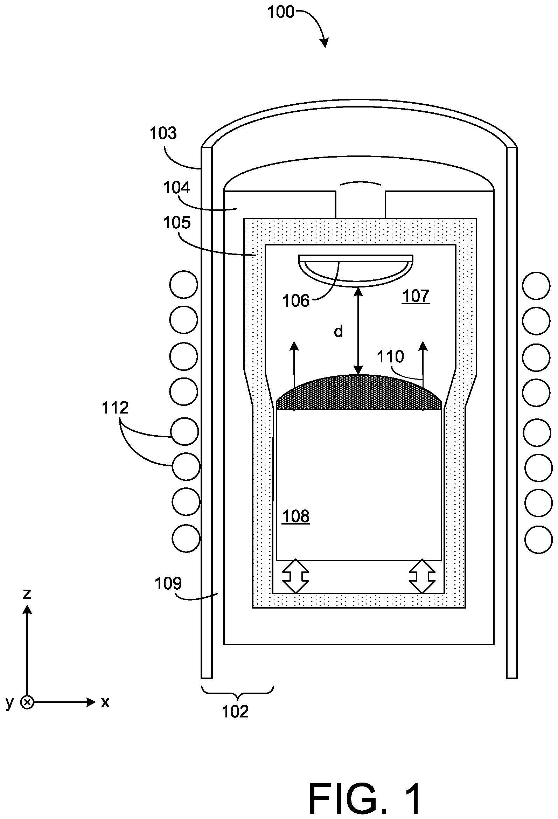

FIG. 1 illustrates a cross-sectional view of a PVT furnace 100, in accordance with some implementations of the present disclosure. In some implementations, the PVT furnace 100, e.g., a sublimation furnace, can include an outer shell 102, a crucible 105, a seed crystal 106, a moveable source 108, and heaters 112.

In some implementations, the outer shell 102 can be a multi-layer cylindrical structure that includes an outer chamber wall 103 and a thermal insulation sleeve 104 outside the crucible 105. In some implementations, the crucible 105 can be a closed container that defines a growth cell 107. The growth cell 107 may be evacuated so that a SiC boule can be grown in a high purity, low pressure environment. In some implementations, the outer chamber wall 103 can be made of quartz, the thermal insulation sleeve 104 can be made of low density graphite, and the crucible 105 can be made of high density graphite. Because graphite is highly conductive of both heat and electricity, the graphite material supports inductive heating of the crucible 105, surrounding the growth cell 107.

In some implementations, the SiC seed crystal 106 can be attached to a seed module suspended from an upper end of the crucible 105. In some implementations, the SiC seed crystal 106 can have a thickness in the z-direction of about 1 mm. In some implementations a pyrometer can be mounted adjacent to the seed crystal 106 to monitor temperature of the seed crystal 106.

In some implementations, an air gap 109 can separate the outer chamber wall 103 from the thermal insulation sleeve 104. In some implementations, a width of the air gap 109 can range between about 3 mm and about 7 mm. In some implementations, another inert gas, e.g., nitrogen gas (N₂), can be substituted for air in the air gap 109.

In some implementations, the heaters 112 can be disposed around the outer shell 102, e.g., sidewall, of the crucible, outside the "hot zone." In some implementations, the heaters 112 can take the form of fixed RF induction coils that wrap around the outer shell 102, to surround the crucible 105, where turns of the coil(s) are represented in FIG. 1 by circles. The induction coils of the heaters 112 induce electric currents to flow within the crucible 105. In some implementations, the heaters 112 can be considered as horizontal heating elements because they influence temperature gradients in the x-y, or radial, planes along the z-axis.

In the PVT furnace 100, SiC source material can be disposed in a lower region of the crucible 105 while the seed crystal 106 is disposed in an upper region of the crucible 105. In some implementations, the SiC source material, e.g., a SiC precursor, may be in the form of a powder having a 1:1 ratio of silicon to carbon. The SiC source material can be contained in a source capsule of the moveable source 108. In some implementations, the moveable source 108 can be in the form of a donut-shaped, or toroidal, source capsule, in which the temperature can be maintained by the heaters 112 as substantially uniform, because such a source capsule excludes the center of the crucible 105 that is farthest away from the heaters 112. Using the heaters, the crucible 105 can be heated to a temperature in a range of about 1800 degrees C to about 2500 degrees C, until the solid SiC source materials sublimate to form a gas 110. The gas 110 rises within the growth cell 107 toward the seed crystal 106, which is at a lower temperature than the gas 110. When the gas 110 encounters the seed crystal 106, the gas 110 condenses onto side and bottom-facing surfaces of the seed crystal 106, causing crystal growth to progress radially outward from the seed crystal 106 and axially downward in the - z direction. The moveable source 108 can translate downward as the crystalline boule grows in the growth cell 107, to maintain a substantially constant distance d between the source zone, e.g., the moveable source 108, and the crystal growth interface. In some implementations, it may be desirable for the distance d to accommodate growth of an ingot having a final length of at least about 60 mm, e.g., in a range of about 55 mm to about 65 mm so that the ingot can produce a large number of wafers. In some implementations, the moveable source 108 can move in response to expansion or contraction of materials in the source capsule. For example, smart materials can be used in construction of the source capsule and/or the crucible 105 that expand and shrink with changes in temperature. Thus, a top surface of the moveable source 108 can contract as the boule grows, to maintain a substantially constant distance d and a substantially constant temperature difference between the source and the boule.

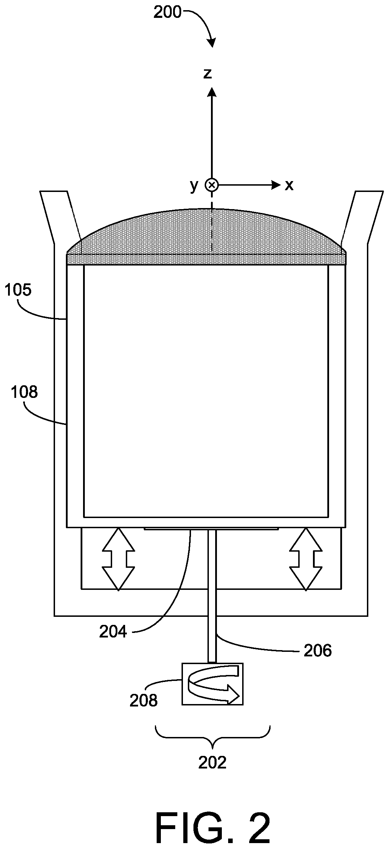

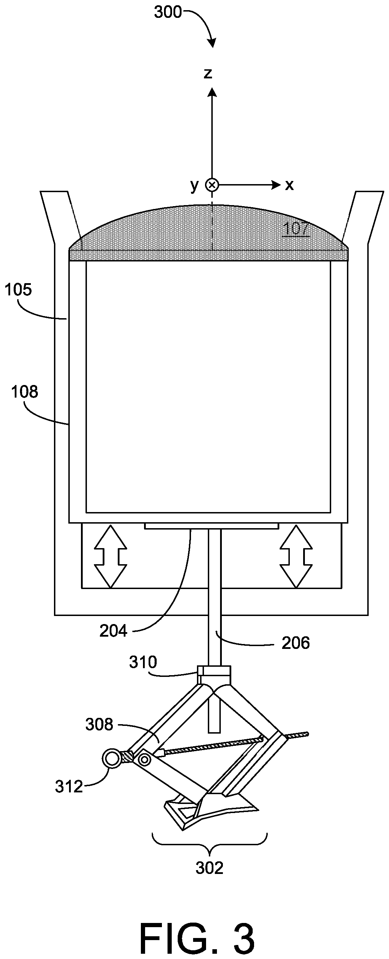

FIG. 2 and FIG. 3 are magnified views of the PVT furnace 100, in accordance with some implementations of the present disclosure. FIG. 2 and FIG. 3 further illustrate details of the PVT furnace 100 relating to the moveable source 108. In particular, FIG. 2 and FIG. 3 illustrate motive devices that can be used to adjust a position of the moveable source capsule relative to the SiC ingot during growth of the SiC ingot.

FIG. 2 illustrates an example of a min which the moveable source 108 can be moved up and down inside the closed graphite crucible 105 by a first drive assembly 202 attached to the moveable source 108. The first drive assembly 202 can be configured for one-dimensional e.g., vertical translational motion of the moveable source 108. In some implementations, the first drive assembly 202 can include a rigid connector 204, a central drive shaft 206, and a drive motor 208. The rigid connector 204 can be attached to the moveable source 108, e.g., attached to an underside surface of the moveable source 108. The rigid connector 204 can be configured to couple the moveable source 108 to the central drive shaft 206. In some implementations, the central drive shaft 206 extends through a sealed bottom wall of the crucible 105 to the drive motor 208. In some implementations, the drive motor 208 can be rotationally coupled to the drive shaft 206 such that rotation of the drive motor 208 causes vertical translational motion of the drive shaft 206 and the rigid connector 204 along a central z-axis, thereby altering the vertical position of the moveable source 108.

FIG. 3 illustrates an example in which the moveable source 108 can be moved up and down inside the closed graphite crucible 105 by a second drive assembly 302 coupled to the moveable source 108. Like the first drive assembly 202, the second drive assembly 302 can be configured for one-dimensional e.g., vertical translational motion of the moveable source 108. In some implementations, the second drive assembly 302 can include the rigid connector 204, the central drive shaft 206, and a lifting mechanism 308 such as, for example, a scissor jack, a screw jack, an inflatable jack, a floor jack, or other type of equipment lifting device that can be disposed underneath the crucible 105. The rigid connector 204 can be attached to the moveable source 108, e.g., attached to an underside surface of the moveable source 108. The rigid connector 204 can be configured to couple the moveable source 108 to the central drive shaft 206. In some implementations, the central drive shaft 206 extends through a sealed bottom wall of the crucible 105 to couple with the lifting mechanism 308. In some implementations, the lifting mechanism308 can be fixed to the drive shaft 206, e.g., by tightening a coupling ring 310. Expansion and contraction of the lifting mechanism308 can be controlled by turning a screw 312. Raising and lowering the lifting mechanism308 then causes vertical translational motion of the drive shaft 206 and the rigid connector 204 along a central z-axis, thereby altering the vertical position of the moveable source 108.

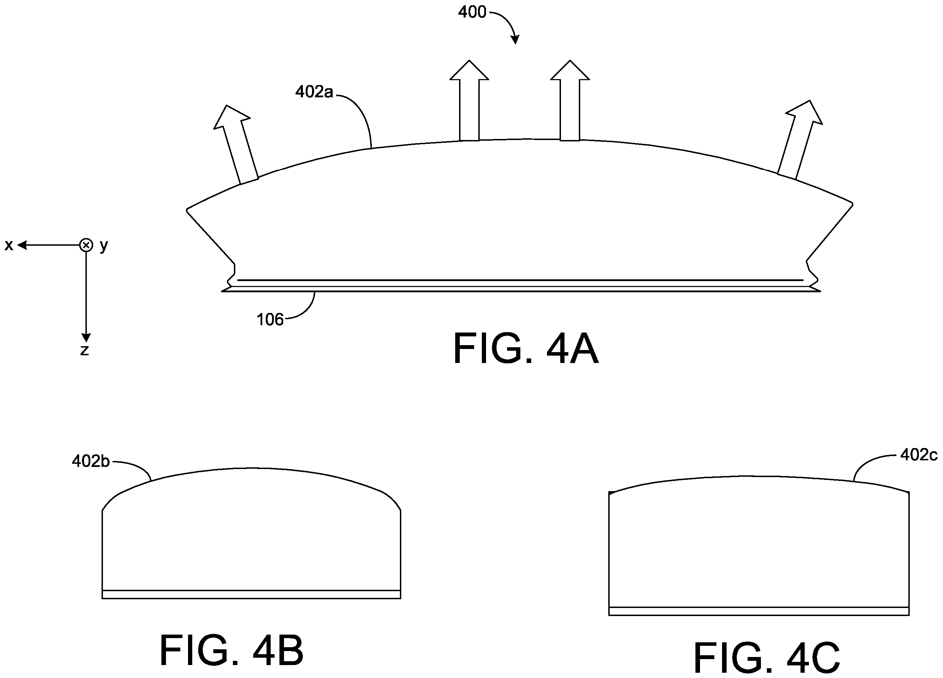

FIGs. 4A-4C are side elevation views of crystal growth, in accordance with some implementations of the present disclosure. FIG. 4A illustrates a crystal growing isotropically outward from the seed crystal 106 in the direction of the arrows, which are normal to a dome-shaped solid-gas interface 402a. In some implementations, the solid-gas interface 402a initially forms a convex surface, e.g., dome, that changes over time as the boule grows. FIG. 4B illustrates a highly convex interface 402b characterized by high thermoelastic stress, which provides good polytype stability. The highly convex interface 402b represents the initial shape of the dome early in the growth cycle. FIG. 4C illustrates a slightly convex interface 402c, which is nearly flat and is characterized by low thermoelastic stress with poor polytype stability, wherein a polytype is a crystalline form having a certain unit cell dimension. The slightly convex interface 402c represents a degraded shape of the dome later in the growth cycle. If the growth cycle is long enough, the shape of the interface may flatten out entirely or become concave. A concave interface switches polytype and creates instability. It is desirable to maintain an interface shape similar to the one shown in FIG. 4B throughout the time interval of crystal growth, as shown in FIGs. 4A-4C and described below. By moving the source capsule downward as the crystal growth progresses, a substantially constant distance can be maintained between the source and the solid-gas interface to preserve the highly convex interface 402b throughout the growth cycle.

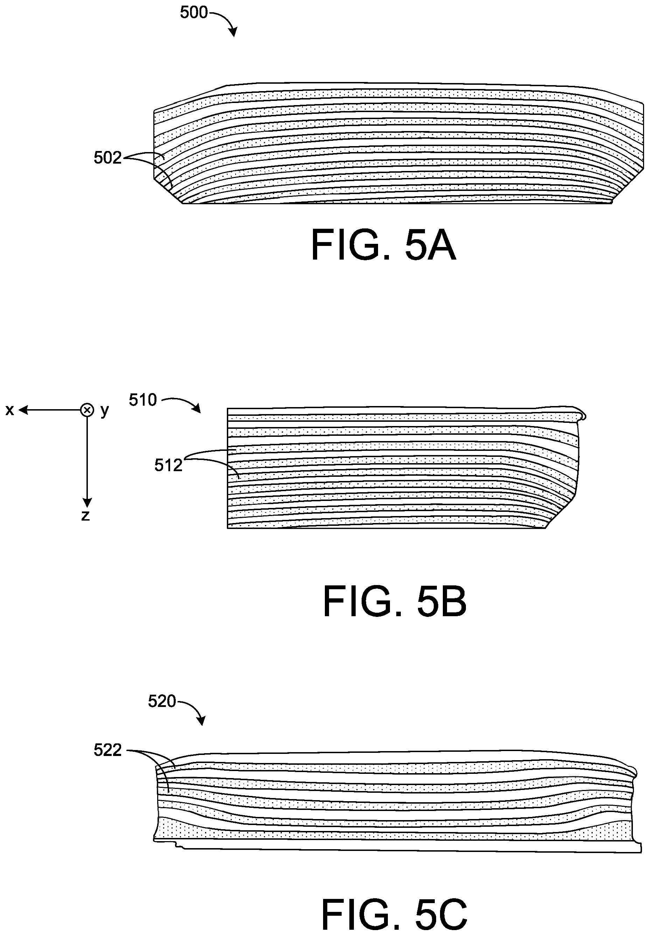

FIGs. 5A-5C are simulation results showing isotherms for various shapes of a crystalline boule, in accordance with some implementations of the present disclosure. Each isotherm is a surface of constant temperature across the boule. Spatially uniform isotherms indicate temperature stability that will tend to result in a low defect density within the crystal. FIG. 5A is a plot 500 showing simulated isotherms 502 of the highly convex crystal illustrated in FIGs. 4A and 4B. FIG. 5B is a plot 510 showing simulated isotherms 512 of the slightly convex crystal illustrated in FIG. 4C. By comparing the isotherms 502 with the isotherms 512, it is evident that the widths of the isotherms 502 of the highly convex crystal are more uniform across the boule in both the +/- x-direction and the +/- z-direction, and therefore more desirable, than the widths of the isotherms 512 of the slightly convex crystal. FIG. 5C is a plot 520 showing simulated isotherms 522 of a concave crystal. The isotherms 522 are shown to be severely distorted, indicating significant temperature variation across the boule in both the +/- x-direction and the +/- z-direction. FIGs 5A-5C indicate that avoiding a concave interface is important for production of a high quality SiC crystal.

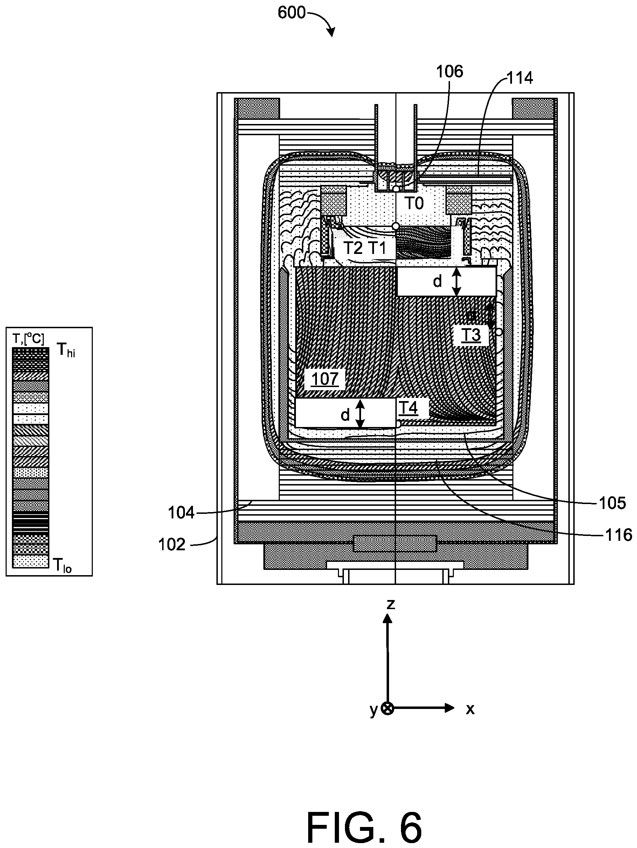

FIG. 6 is a cross-sectional view of the PVT furnace 100, showing the effect of source movement on temperatures, in accordance with some implementations of the present disclosure. The crucible 105 is heated by the heaters 112, e.g., radio frequency inductive heaters, to a temperature of about 2200 C. Because the crucible is made of graphite, an excellent conductor of heat and electricity, the temperature of the crucible quickly reaches an equilibrium, so it is approximately the same on all sides. Temperature contours 600 are shown on the left, when the moveable source 108 is in an uppermost position adjacent to the crystal boule, and on the right, when the moveable source 108 is in a lowermost position, a maximum distance d = 60 mm from the crystal growth interface. The temperature contours appear to be equivalent on both sides of the crucible 105 and on both sides of the crystal boule. T2 represents the source temperature and T1 represents the seed temperature at the growth interface. On both sides of the growth cell 107, the difference T2-T1 is measured to be in a range of about 28 to about 30 degrees C. Thus, there is essentially no difference between the temperature profile on the left side and the right side, indicating that moving the source preserves axial temperature gradients. Consequently, the growth rate of the crystal will remain unchanged by motion of the source.

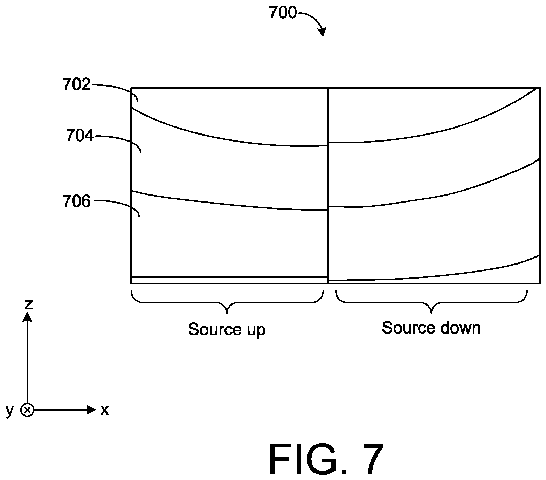

FIG. 7 is a side view of the crystal boule, showing the effect of source movement on the growth interface shape of the crystal, in accordance with some implementations of the present disclosure. A simulated series of shape profiles 700 of the growth interface is shown for the "up" source position on the left, and the "down" source position on the right. Growth fronts are shown at a beginning stage 702, an intermediate stage 704, and a final stage 706 of crystal growth. The series of shape profiles 700 shows that the shape of the growth interface remains convex for both extreme source positions at every stage of crystal growth. Thus, changing the position of the moveable source 108 to maintain a constant distance d from the surface of the boule will easily maintain the desirable convex shape of the growth interface.

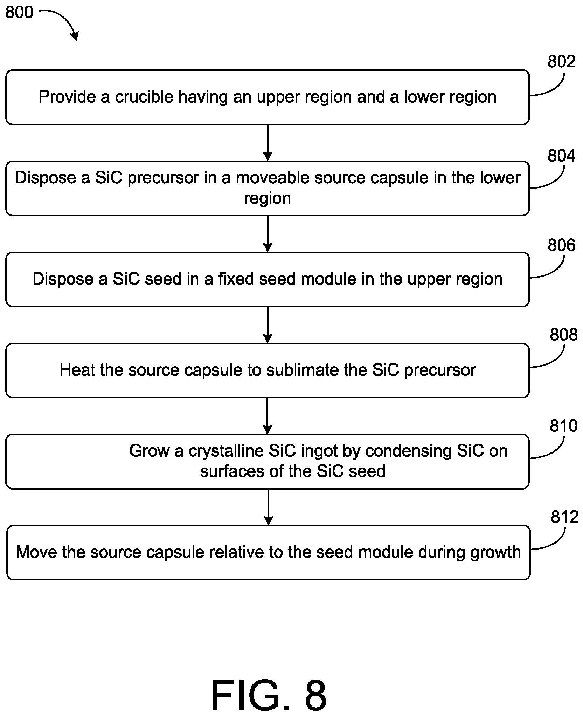

FIG. 8 is a flow chart illustrating a method 800 of forming a SiC boule in accordance with some implementations of the present disclosure. Operations 802-812 of the method 800 can be carried out to form the SiC boule, according to some implementations as described above with reference to FIGs. 1, 2, 3, 4A, 4B, 4C, 5A, 5B, 5C, 6, and 7. Operations of the method 800 can be performed in a different order, or not performed, depending on specific applications. It is noted that the method 800 may not completely form a SiC boule. Accordingly, it is understood that additional processes can be provided before, during, or after method 800, and that some of these additional processes may be briefly described herein.

At 802, the method 800 includes providing a crucible e.g., the crucible 105 of a sublimation furnace, e.g., the PVT furnace 100. In some implementations, the crucible 105 can have an upper region and a lower region.

At 804, the method 800 includes disposing a SiC precursor in a moveable source capsule in the lower region of the crucible 105.

At 806, the method 800 includes disposing a SiC seed crystal, e.g., the seed crystal 106, in a fixed seed module suspended in the upper region of the crucible 105.

At 808, the method 800 includes heating the crucible 105 to sublimate the SiC precursor, using, for example, heaters 112.

At 810, the method 800 includes growing a crystalline SiC ingot, or boule, by condensing SiC on surfaces of the SiC seed.

At 812, the method 800 includes growing a crystalline SiC ingot, or boule, using the moveable source 108 to control temperature gradients during the growth process. By continuously retracting the moveable source 108 in the direction of crystal growth, a constant distance between the source and the solid-gas interface can be maintained so as to sustain a convex interface shape throughout the growth process. This can result in a longer ingot with a lower defect density than can be obtained using a fixed source capsule.

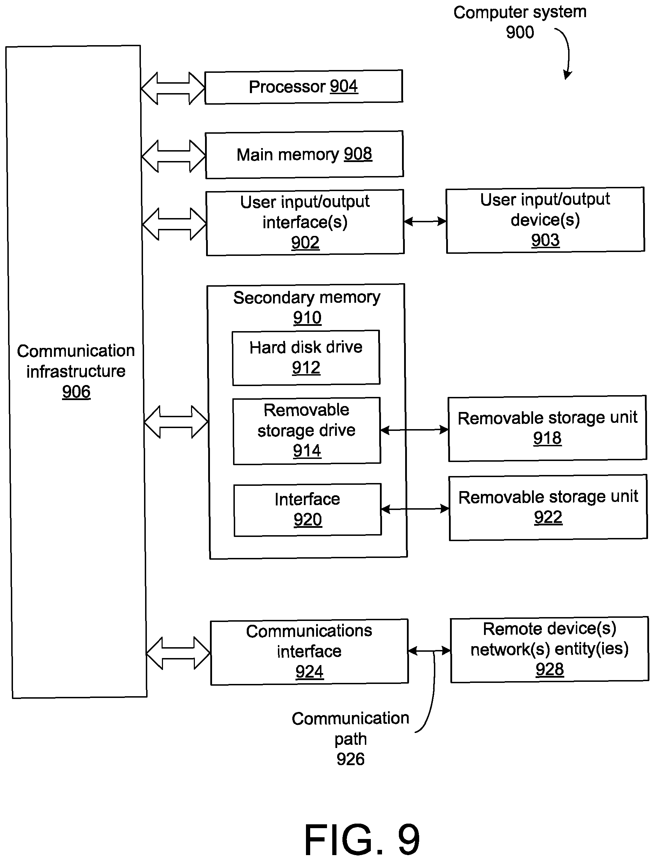

FIG. 9 is an illustration of an example computing system 900 in which various embodiments of the present disclosure can be implemented. The computing system 900 can be any well-known computing system capable of performing the functions and operations described herein. For example, and without limitation, the computing system 900 can provide a hardware platform for implementing the process control scheme(s) described above. The computing system 900 can be used, for example, to execute one or more operations in the method 800, which describes an example method for forming a SiC ingot. In some implementations, the computing system 900 can serve as a feedback control system for the PVT furnace. For example, the computing system 900 can be implemented as a controller coupled to the PVT furnace 100 that monitors one or more temperatures associated with the PVT furnace 100 using, for example, a pyrometer, and, in response, engages a motive device to move a source capsule as described above to provide enhanced process control during a crystal growth process and/or a post-anneal process.

The computing system 900 includes one or more processors (also called central processing units, or CPUs), such as a processor 904. The processor 904 is connected to a communication infrastructure or bus 906. The computing system 900 also includes input/output device(s) 903, such as monitors, keyboards, pointing devices, etc., that communicate with a communication infrastructure or bus 906 through input/output interface(s) 902. The processor 904 can receive instructions to implement functions and operations described herein-e.g., method 800 of FIG. 8-via input/output device(s) 903. For example, the processor 904 can be programmed to activate a motive device, e.g., the drive assembly 202 or the drive assembly 302, to adjust a position of a source capsule relative to a seed crystal while growing a SiC crystalline boule, or while performing an annealing process after completing growth of a SiC ingot. In some implementations, the processor 904 may be programmed to activate the motive device in accordance with temperature measurements. In some implementations, the processor 904 may be programmed to engage he motive device according to a prescribed schedule. The computing system 900 also includes a primary or main memory 908, such as random access memory (RAM). The main memory 908 can include one or more levels of cache. The main memory 908 has stored therein control logic (e.g., computer software) and/or data. In some embodiments, the control logic (e.g., computer software) and/or data can include one or more of the operations described above with respect to the method 800 of FIG. 8.

The computing system 900 can also include one or more secondary storage devices or secondary memory 910. The secondary memory 910 can include, for example, a hard disk drive 912 and/or a removable storage device or drive 914. The removable storage drive 914 can be a floppy disk drive, a magnetic tape drive, a compact disk drive, an optical storage device, tape backup device, and/or any other storage device/drive.

The removable storage drive 914 can interact with a removable storage unit 918. The removable storage unit 918 includes a computer usable or readable storage device having stored thereon computer software (control logic) and/or data. The removable storage unit 918 can be a floppy disk, magnetic tape, compact disk, DVD, optical storage disk, thumb drive, and/or any other computer data storage device. The removable storage drive 914 reads from and/or writes to removable storage unit 918 in a well-known manner.

According to some embodiments, the secondary memory 910 can include other means, instrumentalities or other approaches for allowing computer programs and/or other instructions and/or data to be accessed by the computing system 900. Such means, instrumentalities or other approaches can include, for example, a removable storage unit 922 and an interface 920. Examples of the removable storage unit 922 and the interface 920 can include a program cartridge and cartridge interface (such as that found in video game devices), a removable memory chip (such as an EPROM or PROM) and associated socket, a memory stick and USB port, a memory card and associated memory card slot, and/or any other removable storage unit and associated interface. In some embodiments, the secondary memory 910, the removable storage unit 918, and/or the removable storage unit 922 can include one or more of the operations described above with respect to the method 800 of FIG. 8.

The computing system 900 can further include a communication or network interface 924. The communication interface 924 enables the computing system 900 to communicate and interact with any combination of remote devices, remote networks, remote entities, etc. (individually and collectively referenced by remote devices 928). For example, the communication interface 924 can allow the computing system 900 to communicate with the remote devices 928 over a communications path 926, which can be wired and/or wireless, and which can include any combination of LANs, WANs, the Internet, etc. Control logic and/or data can be transmitted to and from the computing system 900 via the communications path 926.

The operations in the preceding embodiments can be implemented in a wide variety of configurations and architectures. Therefore, some or all of the operations in the preceding embodiments-e.g., the method 800 of FIG. 8-can be performed in hardware, in software or both. In some embodiments, a tangible apparatus or article of manufacture comprising a tangible computer useable or readable medium having control logic (software) stored thereon is also referred to herein as a computer program product or program storage device. This includes, but is not limited to, the computing system 900, the main memory 908, the secondary memory 910 and the removable storage units 918 and 922, as well as tangible articles of manufacture embodying any combination of the foregoing. Such control logic, when executed by one or more data processing devices (such as the computing system 900), causes such data processing devices to operate as described herein.

As described above, the addition of a moveable source capsule to a PVT system can assist in controlling SiC crystal formation. The benefits of tighter process control are obtained mainly by controlling the shape of the crystal growth interface and by reducing axial and radial temperature variation.

It will be understood that, in the foregoing description, when an element, such as a layer, a region, or a substrate, is referred to as being on, connected to, electrically connected to, coupled to, or electrically coupled to another element, it may be directly on, connected or coupled to the other element, or one or more intervening elements may be present. In contrast, when an element is referred to as being directly on, directly connected to or directly coupled to another element or layer, there are no intervening elements or layers present. Although the terms directly on, directly connected to, or directly coupled to may not be used throughout the detailed description, elements that are shown as being directly on, directly connected or directly coupled can be referred to as such. The claims of the application may be amended to recite exemplary relationships described in the specification or shown in the figures.

As used in this specification, a singular form may, unless definitely indicating a particular case in terms of the context, include a plural form. Spatially relative terms (e.g., over, above, upper, under, beneath, below, lower, top, bottom, and so forth) are intended to encompass different orientations of the device in use or operation in addition to the orientation depicted in the figures. In some implementations, the relative terms above and below can, respectively, include vertically above and vertically below. In some implementations, the term adjacent can include laterally adjacent to or horizontally adjacent to.

Some implementations may be implemented using various semiconductor processing and/or packaging techniques. Some implementations may be implemented using various types of semiconductor device processing techniques associated with semiconductor substrates including, but not limited to, for example, silicon (Si), silicon carbide (SiC), gallium arsenide (GaAs), gallium nitride (GaN), and/or so forth.

While certain features of the described implementations have been illustrated as described herein, many modifications, substitutions, changes, and equivalents will now occur to those skilled in the art. For instance, features illustrated with respect to one implementation can, where appropriate, also be included in other implementations. It is, therefore, to be understood that the appended claims are intended to cover all such modifications and changes as fall within the scope of the implementations. It should be understood that they have been presented by way of example only, not limitation, and various changes in form and details may be made. Any portion of the apparatus and/or methods described herein may be combined in any combination, except mutually exclusive combinations. The implementations described herein can include various combinations and/or sub-combinations of the functions, components and/or features of the different implementations described.

## Claims

1. An apparatus, comprising:
a crucible having an upper region and a lower region;
a silicon carbide (SiC) precursor disposed in a moveable source capsule in the lower region;
a SiC seed disposed in the upper region; and
an inductive heater coil surrounding at least a portion of a sidewall of the crucible.

2. The apparatus of claim 1, wherein
the moveable source capsule is donut-shaped, or
the crucible includes graphite.

3. The apparatus of claim 1, further comprising a drive shaft and a drive motor configured to alter a position of the moveable source capsule.

4. The apparatus of claim 1, further comprising a lifting mechanism disposed underneath the moveable source capsule, the lifting mechanism configured to alter a position of the moveable source capsule.

5. The apparatus of claim 1, further comprising smart materials that can expand and shrink with changes in temperature.

6. The apparatus of claim 1, further comprising a pyrometer configured to monitor temperature adjacent to the SiC seed.

7. A system, comprising:
a process chamber for growing a SiC crystal;
a moveable SiC source capsule disposed inside the process chamber;
a heater disposed around sides of the process chamber; and
a controller configured to control a position of the moveable SiC source capsule.

8. The system of claim 7, wherein the controller comprises:
a motive device configured to alter a position of the moveable SiC source capsule; and
a processor programmed to engage the motive device to adjust a position of the moveable SiC source capsule relative to the SiC crystal during growth of the SiC crystal.

9. The system of claim 8, wherein the controller further comprises a pyrometer configured to measure a temperature of the SiC crystal, and the motive device is activated in accordance with temperature measurements.

10. The system of claim 9, wherein
the motive device includes at least one of a lifting mechanism or a drive motor, or
the processor is programmed to engage the heater and the pyrometer to perform an annealing process after growing the SiC crystal.

11. A method of forming silicon carbide, comprising:
disposing a SiC precursor in a source capsule in a lower region of a crucible;
disposing a SiC seed in a fixed seed module in an upper region of the crucible;
heating the source capsule;
forming a SiC crystal by condensing SiC on surfaces of the SiC seed; and
moving the source capsule relative to the fixed seed module while forming the SiC crystal.

12. The method of claim 11, wherein
forming the SiC crystal comprises growing a boule having a final length in a range of about 55 mm to about 65 mm, or
moving the source capsule maintains a substantially constant distance between the SiC seed and the SiC precursor while growing the SiC crystal, or
moving the source capsule maintains a convex profile of a growth interface of the SiC crystal, or
heating the source capsule comprises sublimating the SiC precursor.

13. The method of claim 11, further comprising measuring a temperature above the SiC seed using a pyrometer.

14. The method of claim 11, wherein moving the source capsule maintains a substantially constant temperature difference between a temperature of the SiC crystal and a temperature of the SiC seed while forming the SiC crystal.

15. The method of claim 14, wherein the substantially constant temperature difference is in a range of about 28 to about 30 degrees C.

## Amended claims

### Amended claims in accordance with Rule 137(2) EPC.

1. An apparatus, comprising:
a crucible (105) having an upper region and a lower region;
a silicon carbide (SiC) precursor disposed in a moveable source capsule in the lower region;
a SiC seed disposed in the upper region; and
an inductive heater coil surrounding at least a portion of a sidewall of the crucible *(105),*
**characterized in that**
the moveable source capsule is donut-shaped.

2. The apparatus of claim 1, further comprising a drive shaft (206) and a drive motor (208) configured to alter a position of the moveable source capsule.

3. The apparatus of claim 1, further comprising a lifting mechanism (308) disposed underneath the moveable source capsule, the lifting mechanism (308) configured to alter a position of the moveable source capsule.

4. The apparatus of claim 1, further comprising smart materials that can expand and shrink with changes in temperature.

5. The apparatus of claim 1, further comprising a pyrometer configured to monitor temperature adjacent to the SiC seed.

6. A system, comprising:
a process chamber for growing a SiC crystal;
a moveable SiC source capsule disposed inside the process chamber;
a heater (112) disposed around sides of the process chamber; and
a controller configured to control a position of the moveable SiC source capsule,
**characterized in that**
the moveable source capsule is donut-shaped.

7. The system of claim 6, wherein the controller comprises:
a motive device configured to alter a position of the moveable SiC source capsule; and
a processor (904) programmed to engage the motive device to adjust a position of the moveable SiC source capsule relative to the SiC crystal during growth of the SiC crystal.

8. The system of claim 7, wherein the controller further comprises a pyrometer configured to measure a temperature of the SiC crystal, and the motive device is activated in accordance with temperature measurements.

9. The system of claim 8, wherein
the motive device includes at least one of a lifting mechanism (308) or a drive motor (208), or
the processor is programmed to engage the heater (112) and the pyrometer to perform an annealing process after growing the SiC crystal.

10. A method (800) of forming silicon carbide, comprising:
disposing (804) a SiC precursor in a source capsule in a lower region of a crucible (105);
disposing (806) a SiC seed in a fixed seed module in an upper region of the crucible (105);
heating (808) the source capsule;
forming (810) a SiC crystal by condensing SiC on surfaces of the SiC seed; and
moving (812) the source capsule relative to the fixed seed module while forming the SiC crystal,
**characterized in that**
the moveable source capsule is donut-shaped.

11. The method (800) of claim 10, wherein
forming (810) the SiC crystal comprises growing a boule having a final length in a range of about 55 mm to about 65 mm, or
moving (812) the source capsule maintains a substantially constant distance (d) between the SiC seed and the SiC precursor while growing the SiC crystal, or moving (812) the source capsule maintains a convex profile of a growth interface of the SiC crystal, or
heating (808) the source capsule comprises sublimating the SiC precursor.

12. The method (800) of claim 10, further comprising measuring a temperature above the SiC seed using a pyrometer.

13. The method (800) of claim 10, wherein moving (812) the source capsule maintains a substantially constant temperature difference between a temperature of the SiC crystal and a temperature of the SiC seed while forming the SiC crystal.

14. The method (800) of claim 13, wherein the substantially constant temperature difference is in a range of about 28 to about 30 degrees C.
